# EUROPÄISCHE PATENTSCHRIFT

(11) **EP 0 327 861 B1**
(45) Veröffentlichungstag und Bekanntmachung des Hinweises auf die Patenterteilung: **31.03.1993**
(21) Anmeldenummer: 89100971.4
(22) Anmeldetag: 20.01.1989
(51) Int. Cl.: G06F 11/20

(54) **Redundanzdekoder eines integrierten Halbleiterspeichers**
Redundancy decoder for an integrated semiconductor memory
Décodeur de redondance pour mémoire à semi-conducteur intégrée

(30) Priorität: 10.02.1988 DE 3804065
(43) Veröffentlichungstag der Anmeldung: 16.08.1989
(73) Patentinhaber: SIEMENS AKTIENGESELLSCHAFT, 80333 München (DE)
(72) Erfinder: Hoffmann, Kurt, Prof. Dr., D-8028 Taufkirchen (DE); Kowarik, Oskar, Dr.rer.nat., D-8018 Grafing (DE); Lustig, Bernhard, Dr.rer.nat., D-8000 München 83 (DE); Oberle, Hans-Dieter, Dipl.-Ing., D-8039 Puchheim (DE); Kraus, Rainer, Dipl.-Phys., D-8000 München 83 (DE)

(56) Entgegenhaltungen:
- US-A- 3 755 791
- US-A- 4 689 494
- IEEE JOURNAL OF SOLID-STATE CIRCUITS, Band SC-17, Nr. 5, Oktober 1982, Seiten 863-871, IEEE, New York, US; R.I. KUNG et al.: "An 8K x 8 dynamic RAM with self-refresh"
- PROCEEDINGS OF THE IEEE, Band 74, Nr. 5, Mai 1986, Seiten 684-698, IEEE, New York, US; W.R. MOORE: "A review of fault-tolerant techniques for the enhancement of integrated circuit yield"

## Beschreibung

Die Erfindung betrifft einen Redundanzdekoder eines integrierten Halbleiterspeichers nach dem Oberbegriff des Patentanspruches 1.

Moderne integrierte Halbleiterspeicher enthalten außer den in Zeilen und Spalten angeordneten üblichen Speicherzellen (Normal-Speicherzellen) noch weitere Speicherzellen, sogenannte Redundanz-Speicherzellen. Sie sind über weitere Zeilen und Spalten, sog. redundante Zeilen und redundante Spalten mittels redundanter Dekoder (Redundanzdekoder) adressierbar. Sie dienen dem Ersatz von als fehlerhaft erkannten Normal-Speicherzellen oder von als fehlerhaft erkannten peripheren Teilen zu den Normal-Speicherzellen (z.B. Bitleitungen, Dekoder). Mittels einer solchen Anordnung läßt sich ohne nennenswerten Mehraufwand an Chipfläche und Kosten die Ausbeute an integrierten Halbleiterspeichern bei der Herstellung erhöhen.

Gattungsgemäße Redundanzdekoder sind beispielsweise aus der EP-A 0 170 727 bekannt. Übliche Prüfabläufe für Halbleiterspeicher auf Waferebene mit den bekannten Redundanzdekodern sind dabei folgendermaßen gestaltet: In einem ersten Prüfdurchlauf werden die Normal-Speicherzellen des Halbleiterspeichers auf Funktion geprüft, beispielsweise mittels Paralleltesten wie in EP-A 0 186 040. Werden dabei Defekte erkannt, so werden vorgesehene, zunächst deaktivierte Ersatzdekoder, die sogenannten Redundanzdekoder, irreversibel aktiviert. Dies führt im Betrieb zu einem ebenfalls irreversiblen Deaktivieren der die defekten Speicherbereiche auswählenden (Normal-)Dekoder. Üblicherweise geschieht das Aktivieren der Redundanzdekoder durch Auftrennen vorgesehener Verbindungen. Meist sind dies sogenannte Laserfuses, die mit Hilfe eines Laserstrahls durchschmolzen werden können. Anschließend an diese "Reparatur" der defekten Speicherbereiche wird der Halbleiterspeicher auf Waferebene nochmals auf Funktion geprüft, wobei nun anstelle der deaktivierten defekten Speicherbereiche automatisch die entsprechend aktivierten Ersatzspeicherbereiche geprüft werden. Sind auch die Ersatzspeicherbereiche, zumindest teilweise, defekt, so waren die vorgenommene zeitaufwendige Reparatur und zweite Prüfung umsonst.

Bislang bekannte Verfahren der Testzeitverkürzung durch paralleles Testen mehrerer (Normal-)Speicherbereiche wie z.B. gemäß der US-A 4,055,754, können auf Redundanzspeicherbereiche nur angewendet werden, wenn diese irreversibel aktiviert sind, d.h. nach erfolgter Reparatur in der vorgenannten zweiten Prüfung.

Aufgabe der vorliegenden Erfindung ist es, einen gattungsgemäßen Redundanzdekoder so weiterzubilden, daß er sowohl irreversibel wie auch, beispielsweise im Testbetrieb, reversibel aktivierbar ist.

Diese Aufgabe wird gelöst durch die kennzeichnenden Merkmale des Patentanspruches 1.

Vorteilhafte Aus- und Weiterbildungen sind in Unteransprüchen gekennzeichnet.

Nachstehend wird die Erfindung anhand der FIG näher beschrieben.
- FIG 1: zeigt einen Ausschnitt aus einem Redundanzdekoder nach dem Stand der Technik.
- FIG 2: zeigt eine mögliche Ausgestaltung der Erfindung.

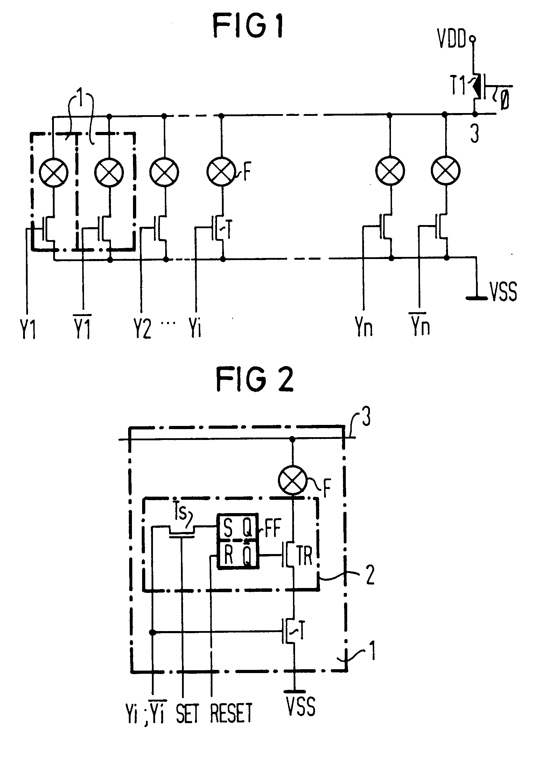

Ein üblicher Redundanzdekoder ist im allgemeinen, wie auch in FIG 1 dargestellt, als sogenannter NOR-Dekoder ausgebildet. Andere Dekodierprinzipien sind möglich und sind auch auf die vorliegende Erfindung anwendbar. Er enthält bei 2ⁿ im Halbleiterspeicher enthaltenen, auswählbaren Zeilen bzw. Spalten für Normal-Speicherzellen 2n zueinander parallel geschaltete Dekoderstufen 1. Der Wert von n ist bestimmt durch die Anzahl der an den Halbleiterspeicher anzulegenden externen Adreßsignale Ai (1 ≦ i ≦ n), die notwendig sind, um eine der Zeilen bzw. Spalten für Normal-Speicherzellen auszuwählen. Jede Dekoderstufe 1 wird im Betrieb durch entweder ein internes Adreßsignal Yi angesteuert oder durch ein zu dem internen Adreßsignal Yi komplementäres Adreßsignal Y̅i̅. Die Erzeugung der internen Adreßsignale Yi,Y̅i̅ aus den externen Adreßsignalen Ai ist beispielsweise aus der DE-AS 26 41 524 bekannt.

Die Steuerung einer Dekoderstufe 1 erfolgt über das Gate eines Schalttransistors T, dessen Source gemeinsam mit den Sources der Schalttransistoren T der restlichen Dekoderstufen 1 beispielsweise mit dem Bezugspotential VSS des Halbleiterspeichers verbunden ist. Die Drain des Schalttransistors T ist mit dem einen Ende einer auftrennbaren Verbindung F verbunden. Meist wird als auftrennbare Verbindung F ein sogenanntes Laserlink, auch Laserfuse genannt, verwendet. Andere mögliche Ausgestaltungen sind dem Stande der Technik entnehmbar. Insbesondere ist aus "Japanese Journal of Applied Physics", Supplements Vol. 22 (1983), Supplemental No. 22-1, Tokyo, Japan, Seiten 63 bis 67 die Verwendung von elektrisch (irreversibel) programmierbaren Polysiliziumfuses bekannt. Das andere Ende der auftrennbaren Verbindung F ist mit den anderen Enden der auftrennbaren Verbindungen F der restlichen Dekoderstufen 1 des Redundanzdekoders verbunden unter Bildung einer gemeinsamen Leitung 3. Der elektrische Zustand der gemeinsamen Leitung 3 bestimmt, ob der Redundanzdekoder als ausgewählt gilt (z.B. durch den Pegel "High") oder als nicht-ausgewählt (entsprechender Pegel "Low").

Um dies zu realisieren, ist bekanntlich die gemeinsame Leitung 3 über einen Ladetransistor T1 mit dem Versorgungspotential VDD verbunden. Das Gate des Ladetransistors T1 ist beispielsweise ebenfalls mit dem Versorgungspotential VDD verbunden. Am Gate kann jedoch auch, wie dargestellt, ein Dekodersteuersignal 0̸ anliegen. Der zeitliche Verlauf des Steuersignales 0̸ ist dann so zu wählen, daß der Ladetransistor T1 außerhalb der Dekodierphase leitend ist, wodurch die gemeinsame Leitung 3 auf dem Versorgungspotential VDD gehalten wird bzw. auf dieses vorgeladen wird und daß der Ladetransistor T1 während der Dekodierphase gesperrt ist, so daß die gemeinsame Leitung 3 zunächst elektrisch schwebend ist ("floatend"), d.h. auf dem vorgeladenen Potential (= auf dem Versorgungspotential VDD) bleibt.

Während der Dekodierphase sind zunächst zwei verschiedene Hardware-Zustände des Redundanzdekoders zu unterscheiden:
a) Der Redundanzdekoder ist nicht als Ersatz für einen Normal-Dekoder programmiert: Alle auftrennbaren Verbindungen F sind noch elektrisch leitend.
b) Der Redundanzdekoder ist als Ersatz für einen bestimmten Normal-Dekoder programmiert, so daß bei Anlegen der entsprechenden Kombination von Adreßsignalen die dem Redundanzdekoder zugeordneten Redundanzspeicherzellen ausgewählt werden.

Im Fall a) sind noch alle auftrennbaren Verbindungen F intakt, d.h. nicht aufgetrennt. Während der Dekodierphase ist genau eine Hälfte der am Redundanzdekoder anliegenden internen Adreßsignale Y1,Y̅1̅, ... Yi,Y̅i̅, ... aktiv (z.B. "high" im Falle von n-Kanal-Transistoren als Schalttransistoren T), wodurch genau die Hälfte der Schalttransistoren T durchgeschaltet ist. Weil alle auftrennbaren Verbindungen F intakt sind, wird das Bezugspotential VSS auf die gemeinsame Leitung 3 durchgeschaltet; diese nimmt ihren nicht-ausgewählten Zustand an.

Im Falle b) spricht der Redundanzdekoder auf eine ganz bestimmte Kombination von Adreßsignalen Yi;Y̅i̅ an, nämlich genau auf diejenige Kombination, auf die er aufgrund des erfolgten Auftrennens der auftrennbaren Verbindungen F programmiert ist. Wird diese Kombination von Adreßsignalen Yi;Y̅i̅ angelegt, so sind zwar bestimmte Schalttransistoren T von Source zu Drain durchgeschaltet. Dies sind jedoch genau diejenigen Schalttransistoren T, deren zugeordnete auftrennbare Verbindungen F unterbrochen sind. Die restlichen Schalttransistoren T sperren. Somit gelangt das Bezugspotential VSS nicht auf die gemeinsame Leitung 3, wodurch auf dieser das Versorgungspotential VDD schwebend erhalten bleibt; der Redundanzdekoder ist ausgewählt.

Wird hingegen eine andere Adreßkombination als die über die aufgetrennten Verbindungen F programmierte Kombination angelegt, so ist bei mindestens einem der leitenden Schalttransistoren T die mit diesem verbundene auftrennbare Verbindung F noch intakt. Damit wird die gemeinsame Leitung 3 auf das Bezugspotential VSS gezogen; der Redundanzdekoder ist nicht-ausgewählt.

Der bislang beschriebene, in FIG 1 dargestellte, bekannte Redundanzdekoder ist nun erfindungsgemäß so weitergebildet (vgl. FIG 2), daß jede Dekoderstufe 1 zusätzlich zum Schalttransistor T und zur auftrennbaren Verbindung F eine Ansteuerschaltung 2 enthält. Diese ist zwischen dem Schalttransistor T und der auftrennbaren Verbindung F angeordnet. Sie dient während der Dekodierphase in dem Fall, in dem die über den Redundanzdekoder ansprechbaren (d.h. z.B. testbaren) redundanten Speicherzellen getestet werden sollen, obwohl der Redundanzdekoder noch nicht programmiert ist (d.h. die auftrennbaren Verbindungen F des Redundanzdekoders sind noch alle intakt), zusammen mit den Ansteuerschaltungen 2 der restlichen Dekoderstufen 1 des Redundanzdekoders dem Unterbinden eines möglichen Stromflusses vom Bezugspotential VSS über die Schalttransistoren T und die auftrennbaren Verbindungen F auf die gemeinsame Leitung 3. Diese bleibt somit auf dem Versorgungspotential VDD, wodurch die obengenannten redundanten Speicherzellen ausgewählt sind. Die Ansteuerschaltung 2 simuliert somit trotz intakter auftrennbarer Verbindung F den aufgetrennten Zustand der auftrennbaren Verbindung F, falls die Ansteuerschaltung 2 aktiviert ist. Einem solchermaßen ausgebildeten Redundanzdekoder ist über die Ansteuerschaltungen 2 seiner Dekoderstufen 1 somit temporär die Adresse einer (temporär zu ersetzenden) Zeile bzw. Spalte mit Normal-Speicherzellen einprogrammierbar. Während bei Anlegen einer beliebigen Adresse an den Halbleiterspeicher der dieser beliebigen Adresse zugeordnete Normaldekoder aktiviert wird, werden bei Anlegen derjenigen Adresse, auf die der Redundanzdekoder temporär "programmiert" ist, dieser Redundanzdekoder aktiviert und der entsprechende Normaldekoder über bekannte Steuersignale (vgl. EP-A 0 170 727) deaktiviert. Je Halbleiterspeicher können mehrere erfindungsgemäße Redundanzdekoder vorgesehen sein, die auf verschiedene Adressen temporär programmierbar sind.

Zum Zwecke der temporären Programmierung und Aktivierbarkeit enthält die Ansteuerschaltung 2 in einer möglichen Ausgestaltung der Erfindung eine Speicherschaltung FF. Die Speicherschaltung FF kann eine bistabile Kippstufe sein, beispielsweise in Form eines getakteten oder ungetakteten RS-Flip-Flops. Die zu speichernden Zustände ("Redundanzdekoder für eine bestimmte Adreßkombination temporär programmieren oder nicht?") werden je Dekoderstufe 1, d.h. also auch je Ansteuerschaltung 2, über das der jeweiligen Dekoderstufe 1 zugeordnete interne Adreßsignal Yi bzw. Y̅i̅ in Verbindung mit Steuersignalen SET bzw. RESET zugeführt. Durch die Zuführung über ein Adreßsignal Yi;Y̅i̅ je Dekoderstufe 1 läßt sich jeder im Halbleiterspeicher vorhandene Redundanzdekoder individuell auf eine eigene Adreßkombination programmieren. Somit lassen sich verschiedene Redundanzdekoder über verschiedene Adreßkombinationen frei wählbar ansprechen.

Es ist jedoch auch möglich, anstelle der internen Adreßsignale Yi bzw. Y̅i̅ das Versorgungspotential VDD oder (bei invertierter Logik) das Bezugspotential VSS des Halbleiterspeichers zu verwenden. In diesem Falle ist es allerdings nicht möglich, dem Redundanzdekoder eine bestimmte Adresse zuzuordnen, unter der er (temporär) aktivierbar ist. Statt dessen ist er unabhängig von einer über die Schalttransistoren T an den Redundanzdekoder angelegten Adreßkombination temporär aktivierbar. Dies kann dann sinnvoll sein, wenn alle vorhandenen Redundanzdekoder samt deren zugeordnete Redundanz-Speicherbereiche parallel zueinander geprüft werden sollen oder wenn der Halbleiterspeicher nur einen einzigen Redundanzdekoder für eine redundante Zeile und/oder Spalte enthält.

Das interne Adreßsignal Yi bzw. Y̅i̅ ist in der Ausführungsform nach FIG 2 dem Setzeingang S der Speicherschaltung FF über einen Steuertransistor Ts zugeführt. Der Steuertransistor Ts ist an seinem Gate mit einem als Steuersignal wirkenden Setzsignal SET verbunden. Zum Einschalten der Funktion "temporäres Simulieren eines (in Wirklichkeit nicht) aufgetrennten Zustandes der in der jeweiligen Dekoderstufe enthaltenen auftrennbaren Verbindung F" ist das Setzsignal SET für alle Dekoderstufen 1 eines Redundanzdekoders während eines Taktzyklus des Halbleiterspeichers aktiviert. Eine gleichzeitig am Redundanzdekoder anliegende Adreßkombination aus Adreßsignalen Yi,Y̅i̅ wird in die Kippschaltungen FF des Redundanzdekoders eingespeichert. Tritt bei nachfolgenden Adressiervorgängen (in denen das Setzsignal SET dann nicht mehr aktiviert ist) genau diese Adreßkombination auf, so wird der Redundanzdekoder aktiviert unter gleichzeitiger Deaktivierung mindestens des auf dieselbe Adreßkombination üblicherweise ansprechenden Normal-Dekoders (vgl. EP-A 0 170 727). Für verschiedene Redundanzdekoder sind, falls verschiedene Adressen einprogrammiert werden sollen, verschiedene Setzsignale SET1,SET2 ... vorzusehen.

Je Dekoderstufe 1 ist der negierte Ausgang Q̅ der Speicherschaltung FF mit dem Gate eines Redundanztransistors TR verbunden. Dieser ist mit Source und Drain zwischen dem Schalttransistor T und der auftrennbaren Verbindung F angeordnet. Im Normalfall, in dem der Redundanzdekoder nicht temporär programmiert ist, ist der Redundanztransistor TR elektrisch leitend, d.h. durchgeschaltet. Damit wird das an der Drain des Schalttransistors T anliegende, von einer der internen Adressen Yi,Y̅i̅ abhängige elektrische Signal auf die auftrennbare Verbindung F durchgeschaltet. In dem Fall jedoch, in dem der Redundanzdekoder als "programmiert" zu simulieren ist, sperren bei Anlegen der programmierten Adreßkombination genau diejenigen Redundanztransistoren TR, deren zugeordnete auftrennbare Verbindung F aufgrund der Adreßkombination als "aufgetrennt" zu simulieren ist.

Mittels eines (ggf. allen Redundanzdekodern eines Halbleiterspeichers gemeinsamen) als weiteres Steuersignal wirkenden Resetsignals RESET, das dem Reseteingang R jeder Speicherschaltung FF zuführbar ist, läßt sich der temporär simulierte Zustand der Redundanzdekoder für alle Ansteuerschaltungen 2 eines bzw. aller vorhandenen Redundanzdekoder gleichzeitig wieder aufheben.

Die Steuersignale SET und RESET sind entweder über externe Anschlüsse des Halbleiterspeichers den Redundanzdekodern zuführbar oder sie sind in einer einfachen Zusatzschaltung aus an bereits vorhandenen externen Anschlüssen (z.B. Adreßübernahmesignale R̅A̅S̅ bzw. C̅A̅S̅) des Halbleiterspeichers anliegenden externen Steuersignalen, welche beispielsweise in einem Testautomaten erzeugbar sind, erzeugbar. Während dieser Zuführungs-bzw. Erzeugungsphase übernehmen die externen Anschlüsse diese Sonderfunktion (Anlegen bzw. Steuern des Erzeugens der Steuersignale); ansonsten weisen sie ihre normale Funktion auf (z.B. Adreßübernahmesteuerung R̅A̅S̅,C̅A̅S̅). Die dazu notwendige Unterscheidung der Funktion der an den externen Anschlüssen anliegenden Signale kann auf verschiedene Weise erfolgen. Eine der bekanntesten Maßnahmen ist beispielsweise die Verwendung von Schwellwertschaltern (vgl. DE-A 30 30 852 und DE-A 33 18 564). Eine andere, elegante Möglichkeit der Unterscheidung verschiedener Funktionen von Anschlüssen ist aus dem "COMMITEE LETTER BALLOT" von March 18, 1987 des JEDEC, Solid State Products Engineering Council bekannt.

Der Prüfablauf eines Halbleiterspeichers mit Redundanzdekodern nach dem Stand der Technik auf Waferebene kann beispielsweise folgendermaßen aussehen:
a) paralleles Testen der Normalspeicherzellen
b) Ergebnis positiv: weiter mit Schritt (f)
c) Ergebnis negativ: ermitteln der Adressen der defekten Speicherzellen bzw. Wort- bzw. Bitleitungen bzw. Dekoder etc.
d) (Bleibendes) Programmieren der Redundanzdekoder mit den defekten Adressen (z.B. mittels Durchtrennen der Laserfuses)
e) Nochmaliges Prüfen des Halbleiterspeichers, um festzustellen, daß einerseits das Programmieren erfolgreich war und andererseits die aktivierten redundanten Speicherbereiche in Ordnung sind.
f) Montieren von Gehäusen für die intakten Halbleiterspeicher.

Bei den Schritten c) und e) ist Paralleltesten nicht möglich.

Bei Verwendung der erfindungsgemäßen Redundanzdekoder im Halbleiterspeicher ist nun folgender modifizierte Prüfungsablauf auf Waferebene möglich:
1.) Schritte a) und b) wie vorstehend,
2.) Ergebnis negativ: Redundante Speicherbereiche prüfen durch temporäre elektrische Simulation des aufgetrennten Zustandes der auftrennbaren Verbindungen F,
3.) Ergebnis auch negativ: Halbleiterspeicher ist Totalausfall,
4.) Ergebnis positiv: Schritte c) und d) wie vorstehend,
5.) Schritt f) wie vorstehend; impliziert, daß evtl. auch Halbleiterspeicher montiert werden, bei denen die bleibende Programmierung fehlgeschlagen ist.

Der Vorteil, der sich aufgrund der vorliegenden Erfindung bei dieser Reihenfolge der Herstellungsschritte für einen Halbleiterspeicher ergibt, liegt im Wegfall des Schrittes e). Damit entfällt nicht nur eine ggf. sehr lange Prüfzeit (hohe Speicherkapazität bedingt bekanntlich überproportional hohe Prüfzeiten), sondern es entfällt vor allem auch der zugehörige nochmalige Prüffelddurchlauf mit den zugehörigen Rüstzeiten. Ein Nachteil ist, daß vor der Montage nicht mehr überprüft wird, ob die bleibende Programmierung selbst (d.h. z.B. das Durchschmelzen der Laserfuses selbst) erfolgreich verlief. Dieser Fehlertypus ist jedoch, verglichen mit dem Fehlertypus "Defekt in den redundanten Speicherbereichen", sehr gering (das Verhältnis beträgt erfahrungsgemäß ca. 1:10), so daß der beschriebene erzielbare Vorteil weitaus gewichtiger ist als der dabei in Kauf genommene geringe Nachteil.

## Patentansprüche

1. Redundanzdekoder eines integrierten Halbleiterspeichers mit einer durch eine gemeinsame Leitung (3) Verbundenen Anzahl von einen Schalttransistor (T) und eine auftrennbare Verbindung (F) enthaltenden Dekoderstufen (1) sowie mit wenigstens einem Ladetransistor (T1), **dadurch gekennzeichnet**, daß jede Dekoderstufe (1) außerdem eine Ansteuerschaltung (2) enthält, die zwischen dem Schalttransistor (T) und der auftrennbaren Verbindung (F) angeordnet ist und mittels der bei intakter auftrennbarer Verbindung (F) ein aufgetrennter Zustand der Verbindung (F) elektrisch simulierbar ist.

2. Redundanzdekoder nach Anspruch 1, **dadurch gekennzeichnet**, daß die Ansteuerschaltung (2) eine Speicherschaltung (FF) enthält, deren zu speichernde Zustände über ein der jeweiligen Dekoderstufe (1) zugeordnetes Adreßsignal (Yi;Y̅i̅) sowie über Steuersignale (SET,RESET) eingebbar sind und deren Ausgangssignal die Simulation des aufgetrennten Zustandes der auftrennbaren Verbindung (F) steuert.

3. Redundanzdekoder nach Anspruch 2, **dadurch gekennzeichnet**, daß das Adreßsignal (Yi;Y̅i̅) über einen Steuertransistor (Ts) der Speicherschaltung (FF) zuführbar ist.

4. Redundanzdekoder nach Anspruch 2 oder 3, **dadurch gekennzeichnet**, daß die Speicherschaltung (FF) eine bistabile Kippstufe ist.

5. Redundanzdekoder nach Anspruch 4, **dadurch gekennzeichnet**, daß die bistabile Kippstufe vom RS-Typ ist.

6. Redundanzdekoder nach einem der Ansprüche 2 bis 5, **dadurch gekennzeichnet**, daß anstelle der Adreßsignale (Yi;Y̅i̅) das Versorgungspotential (VDD) oder das Bezugspotential (VSS) des Halbleiterspeichers zur Ansteuerung der Ansteuerschaltung (2) verwendet ist.

7. Redundanzdekoder nach einem der Ansprüche 2 bis 6, **dadurch gekennzeichnet**, daß die Speicherschaltung (FF) mittels eines Redundanztransistors (TR) an den Schalttransistor (T) und die auftrennbare Verbindung (F) angekoppelt ist.

## Claims

1. Redundancy decoder of an integrated semiconductor memory having a number of decoder stages (1) which contain a switching transistor (T) and a fusible link (F) and which are connected via a common line (3), and having at least one charging transistor (T1), characterised in that each decoder stage (1) additionally contains an addressing circuit (2) which is arranged between the switching transistor (T) and the fusible link (F), and by means of which it is possible to simulate electrically a severed condition of the link (F) when the fusible link (F) is intact.

2. Redundancy decoder according to Claim 1, characterised in that the addressing circuit (2) contains a memory circuit (FF), the conditions to be stored of which can be entered via an address signal (Yi; Y̅i̅) assigned to the respective decoder stage (1) as well as via control signals (SET, RESET), and the output signal of which controls the simulation of the severed condition of the fusible link (F).

3. Redundancy decoder according to Claim 2, characterised in that the address signal (Yi; Y̅i̅) can be supplied to the memory circuit (FF) via a control transistor (Ts).

4. Redundancy decoder according to Claim 2 or 3, characterised in that the memory circuit (FF) is a bistable flip-flop.

5. Redundancy decoder according to Claim 4, characterised in that the bistable flip-flop is of the RS type.

6. Redundancy decoder according to one of Claims 2 to 5, characterised in that the supply potential (VDD) or the reference potential (VSS) of the semiconductor memory is used for driving the addressing circuit (2) instead of the address signals (Yi; Y̅i̅).

7. Redundancy decoder according to one of Claims 2 to 6, characterised in that the memory circuit (FF) can be connected to the switching transistor (T) and the fusible link (F) by means of a redundancy transistor (TR).

## Revendications

1. Décodeur de redondance d'une mémoire intégrée à semiconducteurs, comportant un nombre d'étages de décodage (1), qui sont raccordés par une ligne commune (3) et qui comportent un transistor de commutation (T) et une liaison (F) pouvant être interrompue, ainsi qu'au moins un transistor de charge (T1), caractérisé par le fait que chaque étage (1) du décodeur comporte, en outre, un circuit de commande (2), qui est monté entre le transistor de commutation (T) et la liaison (F) pouvant être interrompue et au moyen duquel, lorsque la liaison (F) qui peut être interrompue est intacte, un état d'interruption de la liaison (F) est susceptible d'être simulé électriquement.

2. Décodeur de redondance suivant la revendication 1, caractérisé par le fait que le circuit de commande (2) comporte un circuit de mémoire (FF), dont les états à mémoriser peuvent être introduits par l'intermédiaire d'un signal d'adresse (Yi; Y̅i̅) associé à l'étage respectif (1) du décodeur et peuvent être introduits par l'intermédiaire de signaux de commande (SET, RESET), et dont le signal de sortie commande la simulation de l'état d'interruption de la liaison (F) susceptible d'être interrompue.

3. Décodeur de redondance suivant la revendication 2, caractérisé par le fait que le signal d'adresse (Yi,Y̅i̅) susceptible d'être envoyé par l'intermédiaire d'un transistor de commande (Ts) au circuit de mémoire (FF).

4. Décodeur de redondance suivant la revendication 2 ou 3, caractérisé par le fait que le circuit de mémoire (FF) est un étage à bascule bistable.

5. Décodeur de redondance suivant la revendication 4, caractérisé par le fait que l'étage à bascule bistable est du type RS.

6. Décodeur de redondance suivant l'une des revendications 2 à 5, caractérisé par le fait qu'à la place des signaux d'adresses (Yi; Y̅i̅), le potentiel d'alimentation (VDD) ou le potentiel de référence (VSS) de la mémoire à semiconducteurs est utilisé pour la commande du circuit de commande (2).

7. Décodeur de redondance suivant l'une des revendications 2 à 6, caractérisé par le fait que le circuit de mémoire (FF) est couplé au moyen d'un transistor de redondance (TR) au transistor de commutation (T) et à la liaison (F) susceptible d'être interrompue.
